(19) Europäisches Patentamt / European Patent Office / Office européen des brevets

(11) **EP 2 517 352 B1**

(12) **FASCICULE DE BREVET EUROPEEN**

(45) Date de publication et mention de la délivrance du brevet:
**20.07.2016 Bulletin 2016/29**

(21) Numéro de dépôt: **10798554.1**

(22) Date de dépôt: **20.12.2010**

(51) Int Cl.:
*H03B 9/14* *(2006.01)*    *H03B 15/00* *(2006.01)*

(86) Numéro de dépôt international:
**PCT/EP2010/070320**

(87) Numéro de publication internationale:
**WO 2011/076768 (30.06.2011 Gazette 2011/26)**

(54) **OSCILLATEUR RADIOFREQUENCE MAGNÉTORÉSISTIF**

MAGNETORESISTIVER HF-OSZILLATOR

MAGNETORESISTIVE RADIOFREQUENCY OSCILLATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.12.2009 FR 0959274**

(43) Date de publication de la demande:
**31.10.2012 Bulletin 2012/44**

(73) Titulaires:
• **Commissariat à l'Énergie Atomique et aux Énergies Alternatives**
**75015 Paris (FR)**
• **Centre National de la Recherche Scientifique**
**75016 Paris (FR)**

(72) Inventeurs:
• **CYRILLE, Marie Claire**
**38650 Sinard (FR)**
• **DELAET, Bertrand**
**38190 Bernin (FR)**
• **EBELS, Ursula**
**38100 Grenoble (FR)**
• **HOUSSAMEDDINE, Dimitri**
**38100 Grenoble (FR)**

(74) Mandataire: **Colombo, Michel et al Brevinnov**
**310 avenue Berthelot**
**69008 Lyon (FR)**

(56) Documents cités:
**WO-A1-2009/130738    US-A1- 2008 094 760**

**Description**

L'invention concerne un oscillateur radiofréquence

Par radiofréquence, on désigne des fréquences comprises entre 1 Mhz et quelques centaines de GHz, usuellement comprises entre 1 Mhz et 5 GHz.

Plus particulièrement, l'invention concerne un oscillateur radiofréquence intégrant un dispositif magnétorésistif au sein duquel circule un courant électrique polarisé en spin. Dans un tel oscillateur, le passage du courant provoque une variation périodique de la résistance du dispositif magnétorésistif. Un signal d'horloge est construit à partir de cette variation périodique. La période des variations de la résistivité, et donc la fréquence d'oscillation, peut être réglée en jouant sur l'intensité du courant qui traverse le dispositif magnétorésistif et/ou sur un champ magnétique externe.

De tels oscillateurs ont par exemple vocation à être utilisés dans le domaine des radiotélécommunications car ils peuvent générer une large gamme de fréquences avec un facteur de qualité élevé.

Par facteur de qualité, on désigne ici le rapport suivant :

$$Q = f/\Delta f$$

où :

- Q est le facteur de qualité,
- f est la fréquence d'oscillation de l'oscillateur, et
- $\Delta f$ est la largeur à mi-hauteur de la raie centrée sur la fréquence f dans le spectre de puissance de cet oscillateur.

Les oscillateurs radiofréquences sont issus de l'électronique de spin.

L'électronique de spin utilise le spin des électrons comme degré de liberté supplémentaire afin de générer des effets nouveaux. La polarisation en spin d'un courant électrique résulte de l'asymétrie existant entre la diffusion des électrons de conduction de type "spin-up" (c'est-à-dire parallèle à l'aimantation locale) et de type "spin-down" (c'est-à-dire anti-parallèle à l'aimantation locale). Cette asymétrie conduit à une asymétrie de la conductivité entre les deux canaux de spin-up et down, d'où une polarisation de spin nette du courant électrique.

Cette polarisation en spin du courant est à l'origine de phénomènes magnétorésistifs dans les multicouches magnétiques tels que la magnétorésistance géante (Baibich, M., Broto, J.M., Fert, A., Nguyen Van Dau, F., Petroff, F., Etienne, P., Creuzet, G., Friederch, A. and Chazelas, J., " Giant magnetoresistance of (001)Fel(001)Cr magnetic superlattices ", Phys.Rev.Lett., 61 (1988) 2472), ou la magnétorésistance tunnel (Moodera, JS., Kinder, LR., Wong, TM. and Meservey,R.. "Large magnetoresistance at room temperature in ferromagnetic thin film tunnel junctions", Phys.Rev.Lett 74 , (1995) 3273-6).

Par ailleurs, il a également été observé qu'en faisant passer un courant polarisé en spin à travers une couche mince magnétique, on pouvait induire un renversement de son aimantation en l'absence de tout champ magnétique externe (Katine, J.A., Albert, F.J., Buhrman, R.A., Myers, E.B., and Ralph, D.C., "Current-Driven Magnetization Reversal and Spin-Wave Excitations in Co ICu /Co Pillars ", Phys.Rev.Lett. 84, 3149 (2000).).

Le courant polarisé peut également générer des excitations magnétiques entretenues, également dénommées oscillations (Kiselev, S.I., Sankey, J.C., Krivorotov, LN., Emley, N.C., Schoelkopf, R.J., Buhrman, R.A., and Ralph, D.C., "Microwave oscillations of a nanomagnet driven by a spin-polarized current", Nature, 425, 380 (2003)). L'utilisation de l'effet de génération d'excitations magnétiques entretenues dans un dispositif magnétorésistif permet de convertir cet effet en une modulation de résistance électrique directement utilisable dans les circuits électroniques, et donc corollairement, susceptible d'intervenir directement au niveau de la fréquence. Le document US 5 695 864 décrit divers développements mettant en oeuvre le principe physique mentionné précédemment. Il décrit notamment la précession de l'aimantation d'une couche magnétique traversée par un courant électrique polarisé en spin. Les principes physiques mis en oeuvre ainsi que la terminologie utilisée sont également décrits et définis dans la demande de brevet FR 2 892 271.

La fréquence d'oscillation de ces oscillateurs radiofréquences est ajustée en jouant sur l'intensité du courant qui le traverse et, éventuellement en plus, sur un champ magnétique externe.

La demande de brevet US 2007/0 259 209 décrit un oscillateur radiofréquence comportant :

- une couche libre dont l'aimantation précesse quand elle est traversée par un courant polarisé en spin perpendiculairement à son plan,
- un injecteur de courant polarisé en spin dans la couche libre pour faire précesser de façon entretenue son aimantation, cet injecteur présentant une face d'injection du courant polarisé en spin directement en contact avec la couche libre,
- un contact magnétorésistif présentant une face de mesure directement en contact avec la couche libre pour former, en combinaison avec la couche libre, une jonction tunnel permettant de mesurer la précession de l'aimantation de la couche libre,
- un plot conducteur directement en contact avec la couche libre pour faire circuler à travers l'injecteur un courant électrique sans traverser le contact magnétorésistif.

Le plot conducteur est particulièrement avantageux. En effet, si celui-ci était absent, l'intégralité du courant qui traverse l'injecteur devrait également traverser la jonction tunnel. La résistivité de la jonction tunnel devrait alors être faible pour pouvoir supporter les fortes densités de courant nécessaires à la précession sans claquage. Les jonctions tunnel de faible résistivité doivent avoir une barrière très fine (par exemple inférieure à un nanomètre).

La barrière tunnel est la couche en matériau non magnétique permettant d'isoler magnétiquement une couche de référence du contact magnétorésistif de la couche libre tout en conservant la polarisation en spin du courant qui la traverse.

Les matériaux non magnétiques sont ici définis comme des matériaux ne présentant pas d'aimantation mesurable en absence de champ magnétique extérieur. Il peut par exemple s'agir des matériaux dépourvus de propriété magnétique ou de matériaux paramagnétiques ou de matériaux diamagnétiques.

Une barrière tunnel très fine correspond à un facteur RA très faible. Le facteur RA est le produit de la résistance de la barrière tunnel avec son aire (ici l'aire est la superficie de la section transversale de la barrière tunnel).

Plus le facteur RA de la barrière tunnel est faible plus la plage de variation de la résistivité de la jonction tunnel est faible (par exemple inférieure à 10 %) et moins bonne est la sensibilité de la jonction tunnel à la précession de l'aimantation dans la couche libre.

On comprend donc qu'en absence de ce plot conducteur, on se trouve devant une contradiction physique apparemment insoluble puisque la barrière tunnel doit à la fois être fine et épaisse ce qui oblige à avoir recours à des compromis peu satisfaisants.

De l'état de la technique est connu de :

- US2008/0094760A1,
- WO2009/130738A1

Bien que l'oscillateur radiofréquence décrit dans la demande US 2007/0259 209 fonctionne correctement, l'invention vise à l'améliorer encore plus.

Elle a donc pour objet un oscillateur radiofréquence dans lequel au moins une partie des faces de mesure et d'injection sont disposées l'une en face de l'autre de chaque côté de la couche libre.

L'amplitude de la précession de l'aimantation de la couche libre est plus forte juste en face de la face d'injection et s'atténue rapidement sur les côtés de cette face d'injection. Dès lors, en mesurant la précession de l'aimantation de la couche libre en face de la face d'injection, la sensibilité du contact magnétorésistif est accrue.

Les modes de réalisation de cet oscillateur radiofréquence peuvent comporter une ou plusieurs des caractéristiques des revendications dépendantes.

Ces modes de réalisation de l'oscillateur radiofréquence présentent en outre les avantages suivants :

- avoir la face de mesure qui s'étend au-delà de la face d'injection accroît encore plus la sensibilité du contact magnétorésistif ;
- avoir la face d'injection qui s'étend au-delà de la face de mesure augmente également la sensibilité de l'oscillateur radiofréquence ;
- avoir la totalité des faces de mesure et d'injection disposées l'une en face de l'autre accroît la sensibilité de l'oscillateur radiofréquence car la précession de l'aimantation est uniquement mesurée là où elle est maximale ;
- raccorder en parallèle le plot conducteur et le contact magnétorésistif à une même source de courant permet de n'utiliser qu'une seule source de courant pour générer à la fois le courant qui traverse uniquement l'injecteur et le courant qui traverse l'injecteur et le contact magnétorésistif ;
- utiliser un polariseur dont la direction de plus facile aimantation est perpendiculaire au plan de la couche libre permet d'améliorer l'amplitude de la précession de l'aimantation dans la couche libre et de générer des oscillations sans avoir à appliquer un champ magnétique externe;
- utiliser la face d'une barrière en matériau non magnétique isolant pour former la face d'injection accroît encore plus la sensibilité de l'oscillateur radiofréquence car les lignes de courant s'évasent plus pour franchir cette barrière ce qui permet d'être sensible à la précession de l'aimantation de la couche libre sur une surface supérieure à la superficie de la face d'injection.

L'invention sera mieux comprise à la lecture de la description qui va suivre, donnée uniquement à titre d'exemple non limitatif et faite en se référant aux dessins sur lesquels :

- la figure 1 est une illustration schématique et en coupe verticale d'un premier mode de réalisation d'un oscillateur radiofréquence,
- les figures 2 à 6 et la figure 8 sont des illustrations schématiques et en coupe verticale d'autres modes de réalisation d'un oscillateur radiofréquence, et
- la figure 7 est une illustration schématique, en coupe horizontale, du mode de réalisation de l'oscillateur radiofréquence de la figure 6.

Dans ces figures, les mêmes références sont utilisées pour désigner les mêmes éléments.

Dans la suite de cette description, les caractéristiques et fonctions bien connues de l'homme du métier ne sont pas décrites en détail. En particulier, pour plus de détail sur la façon de réaliser les différentes couches des oscillateurs radiofréquences décrits ici et en particulier sur les matériaux utilisables à cet effet, il est possible de se référer à la demande de brevet FR 2 892 271.

Dans la suite de cette description, les termes « supérieur », « inférieur », « haut », « bas » sont définis par rapport à la direction verticale représentée par une flèche V sur les figures.

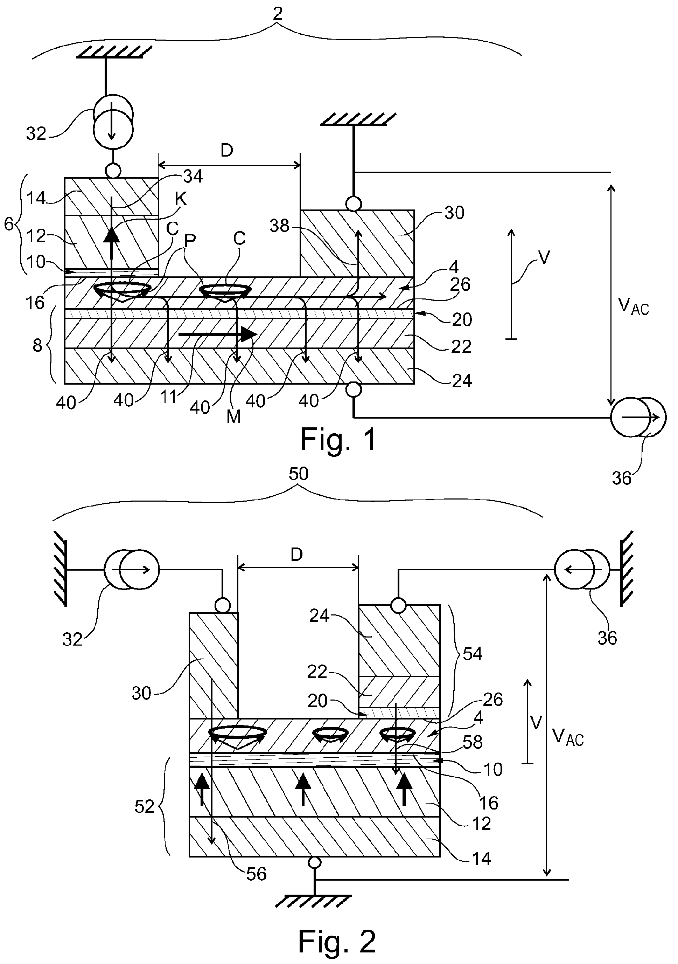

La figure 1 représente un oscillateur radiofréquence 2 en coupe verticale.

L'oscillateur 2 comprend une couche libre 4 horizontale au-dessus de laquelle est disposé un injecteur 6 et en-dessous de laquelle est disposé un contact magnétorésistif 8.

La couche 4 est une couche dont l'aimantation précesse lorsqu'elle est traversée par un courant polarisé en spin perpendiculairement à son plan. Cette précession est entretenue lorsque l'intensité du courant polarisé en spin dépasse l'intensité d'un courant critique $I_c$. Sur la figure 1 comme sur les figures suivantes, la précession de l'aimantation de la couche 4 est symbolisée par des flèches P dont l'extrémité décrit un cercle C. Le diamètre de ce cercle C est représentatif de l'amplitude de la précession de l'aimantation de la couche 4.

La couche 4 est typiquement réalisée dans un matériau magnétique électriquement conducteur. Par exemple, la couche 4 est réalisée en permalloy, en alliage NiFe ou CoFe ou CoFeB ou formée d'une association de deux ou plusieurs couches comme NiFe/CoFe. Cette couche 4 est une couche magnétique douce, c'est-à-dire dont l'aimantation peut facilement s'orienter sous l'effet d'un faible champ extérieur.

Ici, la plus grande dimension dans un plan horizontale de la couche 4 est typiquement inférieure à 10 $\mu$m et de préférence inférieure à 1 $\mu$m. Cette plus grande dimension est par exemple supérieure à 100 nm. Ici, la couche 4 a la forme d'un disque horizontal. Toutefois, d'autres formes sont possibles telles qu'une forme rectangulaire.

L'injecteur 6 permet d'injecter un courant polarisé en spin dans la couche libre 4 propre à déclencher la précession entretenue de l'aimantation de cette couche 4. Ici, l'injecteur 6 se présente sous la forme d'un pilier dont la section horizontale est constante. Par exemple, sa section horizontale est circulaire. La plus grande dimension horizontale de ce pilier est au moins deux fois et de préférence au moins trois fois inférieure à la plus grande dimension de la couche libre 4. Par exemple, le diamètre du pilier est approximativement quatre fois inférieure au diamètre de la couche libre 4.

L'injecteur 6 est disposé à proximité de la périphérie extérieure de la couche 4.

Par exemple, l'injecteur 6 est réalisé par l'empilement des couches suivantes en allant du bas vers le haut :

- un espaceur 10,
- un polariseur 12, et
- une électrode conductrice 14.

Le polariseur 12 polarise en spin le courant qui le traverse verticalement. A cet effet, il s'agit typiquement d'une couche réalisée en matériau magnétique conducteur dont l'épaisseur est suffisante pour polariser en spin les électrons qui la traversent verticalement. Par exemple, l'épaisseur du polariseur 12 est comprise entre 5 nm et 100 nm.

La direction de plus facile aimantation du polariseur 12 est perpendiculaire au plan de la couche 4 et représentée par une flèche K.

Pour plus d'information sur la réalisation d'un tel polariseur, il est possible de se référer à la demande de brevet FR 2 817 998.

L'espaceur 10 permet de découpler magnétiquement le polariseur 12 de la couche libre 4 tout en conservant la polarisation en spin du courant qui le traverse verticalement. A cet effet, l'épaisseur de l'espaceur 10 est choisie judicieusement pour remplir ces fonctions. Cet espaceur 10 présente une face supérieure en contact avec le polariseur 12 et une face inférieure 16, appelée ici « face d'injection » directement en contact avec la face supérieure de la couche libre 4.

Ici, l'espaceur 10 est réalisé dans un matériau non magnétique électriquement conducteur de manière à ce que la combinaison de l'injecteur 6 et de la couche libre 4 forme une magnétorésistance géante (plus connue sous l'acronyme GMR (Giant Magnéto Resistance)). Par exemple, l'espaceur 10 est réalisé en métal tel que du cuivre.

L'électrode 14 disposée sur le polariseur 12 permet de raccorder l'injecteur 6 à une source de courant ou à un potentiel de référence tel que la masse.

Le contact magnétorésistif 8 permet de mesurer la précession de l'aimantation de la couche 4. Plus précisément, la combinaison de ce contact magnétorésistif 8 avec la couche 4 joue le rôle d'un transducteur capable de transformer la précession de l'aimantation de la couche 4 en une variation de résistance.

A cet effet, l'association du contact magnétorésistif 8 et de la couche libre 4 forme une jonction tunnel ou TMR (Tunnel Magnéto Resistance).

Ici, le contact 8 est structuré sous la forme d'un pilier dont la section horizontale est constante. Plus précisément, ce contact 8 est conformé de façon à recouvrir toute la face inférieure de la couche 4. Le contact 8 a donc ici le même diamètre que celui de la couche libre. Ce diamètre est typiquement au moins trois fois supérieur au diamètre de la face d'injection 16.

Le contact 8 est formé de l'empilement successif des trois couches suivantes :

- une barrière tunnel 20,
- une couche de référence 22, et
- une électrode conductrice 24.

La couche de référence 22 présente une direction d'aimantation fixe par rapport à celle de la couche libre 4. Ici, cette direction d'aimantation, représentée par une flèche M, est parallèle au plan de la couche 4. Cette couche 22 peut être une couche simple relativement épaisse (de quelques nanomètres à quelques dizaines de nanomètres, typiquement de l'ordre de 20 nm) réalisée en cobalt, en alliage CoFe ou NiFe par exemple. La couche 22 sert de couche de référence pour la lecture de la magnétorésistance. Elle doit donc être magnétiquement plus stable que la couche 4, c'est-à-dire que sa polarisation doit être plus difficile à modifier que celle de la couche 4. Pour cela, on joue par exemple sur son épaisseur. Par contre, la couche 22 n'a pas pour fonction de polariser en spin les électrons qui la traversent.

Pour réduire l'épaisseur de cette couche 22, celle-ci peut aussi être laminée par insertion de quelques (typiquement 2 à 4) très fines couches en cuivre, d'argent ou d'or d'épaisseur de l'ordre de 0,2 à 0,5 nm. Ces couches insérées sont suffisamment fines pour assurer un fort couplage d'échange dans l'ensemble de la couche laminée de sorte que le piégeage de cette couche reste fort.

La composition typique d'une telle couche de référence laminée peut être (CoFe 1 nm/Cu 0,3 nm)$_3$/CoFe 1 nm). Cette couche de référence peut également être constituée par un antiferromagnétique synthétique plus connu sous l'acronyme SAF (Synthetic Antiferromagnetic) du type (CoFe 3 nm/Ru 0,7 nm)/CoFe 2,5 nm.

Un antiferromagnétique synthétique ou artificiel est un empilement d'au moins deux sous-couches ferromagnétiques, chaque sous-couche étant couplée magnétiquement avec chaque sous-couche ferromagnétique adjacente par un couplage RKKY (Ruderman-Kittel-Kasuya-Yosida) antiferromagnétique. De plus, les sous-couches ferromagnétiques d'un antiferromagnétique synthétique sont dimensionnées pour que l'aimantation globale de l'antiferromagnétique synthétique soit nulle en absence de champ magnétique extérieur.

Pour obtenir un couplage RKKY, les sous-couches ferromagnétiques sont séparées les unes des autres par de fines sous-couches non magnétiques.

Selon l'épaisseur de la sous-couche non magnétique, le couplage RKKY obtenu est :

- soit « antiferromagnétique », c'est-à-dire que les moments magnétiques des deux sous-couches couplées sont antiparallèles,
- soit « ferromagnétique », c'est-à-dire que les moments magnétiques des deux sous-couches couplées sont parallèles.

Dans un antiferromagnétique synthétique, l'épaisseur de la ou des sous-couches non magnétiques est systématiquement choisie pour obtenir un couplage RKKY antiferromagnétique.

Pour plus d'informations sur le couplage RKKY, il est possible de se référer aux deux articles suivants : S. Parkin et al., Physical Review B 44 N°13 (1991) et S. Parkin et al. Physical Review Letters 64 N°19 (1990).

La couche de référence peut être également piégée par une couche antiferromagnétique de manière à fixer son aimantation dans une direction particulière.

Une telle couche antiferromagnétique peut être en Ir$_{20}$Mn$_{80}$ d'épaisseur de 6 à 10 nm ou en Pt$_{50}$Mn$_{50}$ d'épaisseur comprise entre 15 et 30 nm.

La barrière 20 remplit sensiblement la même fonction que l'espaceur 10. Elle est typiquement réalisée dans un matériau non magnétique électriquement isolant. Par exemple, la barrière 20 est ici réalisée en oxyde de magnésium (MgO) de 0,5 à 3 nm d'épaisseur. Cette barrière pourrait aussi être réalisée en oxyde d'aluminium (Alumine Al$_2$O$_3$) d'épaisseur comprise entre 0,5 et 1,5 nm.

Cette barrière 20 présente une face supérieure 26 appelée ici « face de mesure » directement en contact avec la face inférieure de la couche libre 4. Cette face 26 s'étend donc au-delà de la face 16 dans une direction horizontale et, plus précisément, en direction d'un plot conducteur 30. Typiquement, le diamètre de la face 26 est au moins deux fois et, de préférence, au moins trois fois supérieur à celui de la face 16.

La face inférieure de la barrière 20 est directement en contact avec la couche de référence 22.

A cause de ses dimensions, la barrière 20 présente un facteur RA élevé c'est-à-dire au moins supérieur à 1 ou 5 $\Omega\mu m^2$ et de préférence supérieur à 20 ou 50 $\Omega\mu m^2$. Ce facteur RA élevé accroît la sensibilité de l'oscillateur radiofréquence 2.

L'électrode 24 est disposée sous la couche de référence 22. Elle permet de raccorder électriquement le contact 8 à une source de courant ou à un potentiel de référence.

Du fait que les dimensions horizontales de la couche libre 4 sont plusieurs fois supérieures aux dimensions horizontales de la face 16, une partie de la face supérieure de la couche 4 n'est pas occupée par l'injecteur 6. Le plot conducteur 30 est directement déposé sur cette partie dégagée de la face supérieure de la couche 4. Ce plot 30 permet de faire circuler du courant au travers de l'injecteur 6 en limitant la quantité de courant qui traverse le contact 8. Typiquement ce plot 30 est disposé à proximité de la périphérie de la couche 4 diamétralement opposé à l'injecteur 6. Ainsi, le plot 30 est espacé de l'injecteur 6 par une distance horizontale D au moins supérieure à 20 nm. Typiquement, la distance D est également inférieure à 500 nm ou 1 $\mu$m.

Ici, le plot 30 a la forme d'un pilier vertical circulaire dont le diamètre est par exemple compris entre 50 et 150 nm.

Le plot 30 est réalisé dans un matériau métallique non magnétique tel que par exemple du cuivre.

Ici, le plot 30 est raccordé à la masse.

L'oscillateur 2 comprend également une source de courant 32 apte à générer un courant électrique qui traverse l'injecteur 6. A cet effet, la source de courant 32 est directement raccordée à l'électrode 14 de l'injecteur 6. Le courant généré par la source 32 circule à travers l'injecteur 6 en allant du haut vers le bas comme représenté par la ligne de courant 34.

L'oscillateur 2 comprend également ici une autre source de courant 36 apte à générer un courant au travers du contact magnétorésistif 8 pour assurer la lecture du signal utile. La source 36 est conçue pour que l'intensité du courant qui traverse le contact magnétorésistif 8 soit au moins deux fois et, de préférence, au moins dix fois inférieure à celle du courant qui traverse l'injecteur 6.

Lors du fonctionnement de l'oscillateur 2, l'injecteur 6 polarise en spin le courant généré par la source 32. Ce courant polarisé en spin provoque alors la précession de l'aimantation de la couche libre 4. Cette précession de l'aimantation se propage, à partir de la surface d'injection 16 dans la couche libre 4 en s'atténuant d'autant plus que l'on est éloigné de la face d'injection.

Etant donné que la couche 4 et le plot 30 sont réalisés dans des matériaux bons conducteurs, l'essentiel du courant qui traverse l'injecteur 6 circule dans la couche 4 puis le plot 30 avant d'atteindre la masse. Ceci est représenté par une ligne de courant 38.

En parallèle, le courant injecté par la source de courant 36, d'intensité beaucoup plus faible que le courant circulant dans le plot 30, traverse la barrière tunnel 20 permettant ainsi la mesure de la magnétorésistance. Ainsi, la variation de la résistance de la jonction tunnel causée par la précession de l'aimantation de la couche libre 4 est mesurable. Par exemple, cette variation de résistance est représentée par la variation d'une tension $V_{AC}$ entre la masse et l'électrode 24.

Du fait que la face d'injection 16 se trouve en face de la face de mesure 26, le contact magnétorésistif 8 est sensible à la précession de l'aimantation de la couche 4 ayant la plus forte amplitude. Cela contribue donc à augmenter la sensibilité de l'oscillateur 2.

De plus, étant donné que le contact magnétorésistif présente une résistivité beaucoup plus élevée que celle du plot 30, on estime que les lignes de courant qui traversent ce contact 8 tendent à s'étaler au niveau de la barrière 20 comme représenté par les flèches 40. Ainsi, le contact magnétorésistif est non seulement sensible à la précession de l'aimantation juste à la verticale de l'injecteur 6 mais également à la précession de l'aimantation dans l'ensemble de la couche 4. Cela augmente également la sensibilité de l'oscillateur 2.

Enfin, le facteur RA de la barrière 20 est ici élevé.

La figure 2 représente un oscillateur 50 similaire à l'oscillateur 2 mais dans lequel les positions de l'injecteur et du contact magnétorésistif ont été inversées par rapport à celles représentées dans la figure 1. Plus précisément, l'oscillateur radiofréquence 50 comprend un injecteur 52 situé sous la couche libre 4 et un contact magnétorésistif 54 situé sur la couche libre 4.

L'injecteur 52 est par exemple identique à l'injecteur 6 à l'exception du fait que son diamètre est égal au diamètre de la couche libre 4 de manière à ce que la face 16 d'injection recouvre la totalité de la face inférieure de la couche 4.

Le contact 54 est par exemple identique au contact 8 à l'exception que son diamètre est au moins deux fois et de préférence au moins trois fois inférieur au diamètre de la couche libre 4. Dans ces conditions, la face d'injection 16 s'étend au-delà de la face de mesure 26 en direction du plot 30. Par exemple, la face 16 a un diamètre au moins trois fois supérieur à celui de la face de mesure.

Le contact 54 est diamétralement opposé au plot 30 de manière à être séparé de celui-ci par la distance D. Comme précédemment cette distance D est supérieure à 20 nm et, de préférence, inférieure à 1 $\mu$m ou 500 nm.

Dans ce mode de réalisation de l'oscillateur radiofréquence 50, la source de courant 32 est directement raccordée au plot 30 tandis que l'électrode 14 est raccordée à la masse.

La source de courant 36 est quant à elle toujours directement raccordée à l'électrode 24. Des lignes de courant 56 et 58 illustrent la circulation du courant dans l'oscillateur 50.

Dans ce mode de réalisation, étant donné que la face de mesure est en face de la face d'injection, la sensibilité de l'oscillateur est accrue. De plus, puisque la couche 10 est conductrice, la propagation de la précession de l'aimantation dans la couche 4 permet d'amplifier la précession de l'aimantation à l'aplomb de la face de mesure 26.

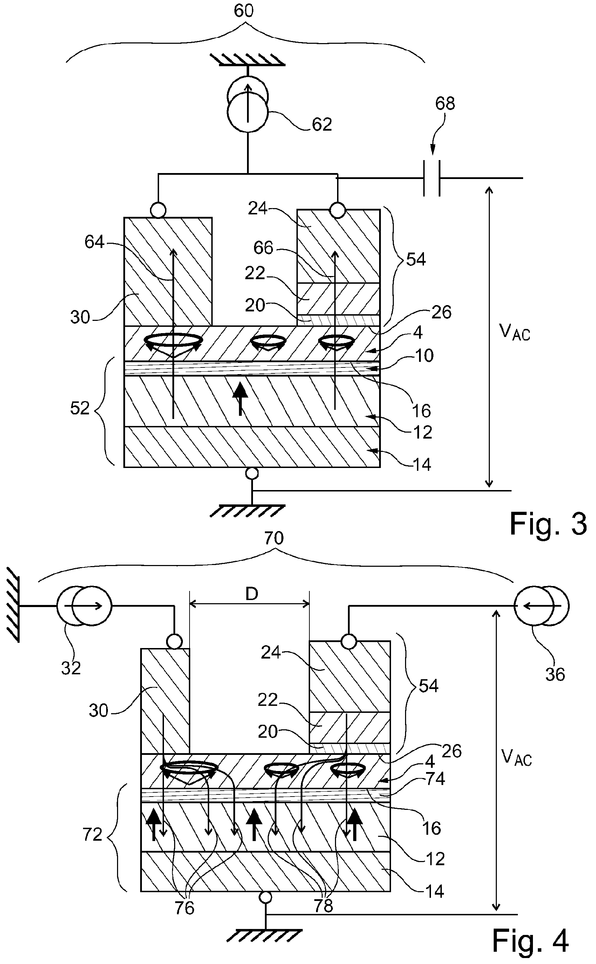

La figure 3 représente un oscillateur radiofréquence 60 identique à l'oscillateur radiofréquence 50 à l'exception du fait qu'une seule source de courant 62 est utilisée pour faire circuler le courant à travers le plot 30 et le contact magnétorésistif 54. Ici, la source de courant 62 est directement raccordée au plot 30 et à l'électrode 24 du contact 54. Ainsi, le plot 30 et le contact 54 sont raccordés en parallèle aux bornes de la source 62.

Des lignes de courant 64 et 66 illustrent la circulation du courant dans l'oscillateur 60. La tension $V_{AC}$ entre l'électrode 24 et l'électrode 14 est représentative de la précession de l'aimantation dans la couche 4. Un condensateur 68 isole les bornes entre lesquelles la tension $V_{AC}$ est mesurée de l'électrode 24.

La figure 4 représente un oscillateur radiofréquence 70 identique à l'oscillateur radiofréquence 50 à l'exception du fait que l'injecteur 52 est remplacé par un injecteur 72.

L'injecteur 72 est par exemple identique à l'injecteur 52 sauf que l'espaceur 10 est remplacé par une barrière tunnel 74 réalisée dans un matériau non magnétique électriquement isolant. Typiquement, cette barrière 74 présente une faible résistivité. Par exemple, le facteur RA de la barrière 74 est strictement inférieure 5 $\Omega\mu m^2$. La résistivité de la barrière 74 reste cependant très supérieure (par exemple dix fois supérieure) à la résistivité d'un espaceur réalisé dans un matériau non magnétique électriquement conducteur.

On estime que cette résistivité accrue de la barrière 74 provoque un étalement des lignes de courant tel que représenté par les flèches 76 et 78 au niveau de l'interface entre la face d'injection 16 et la couche libre 4. Cet étalement des lignes de courant au niveau de cette interface améliore la sensibilité de l'oscillateur 70.

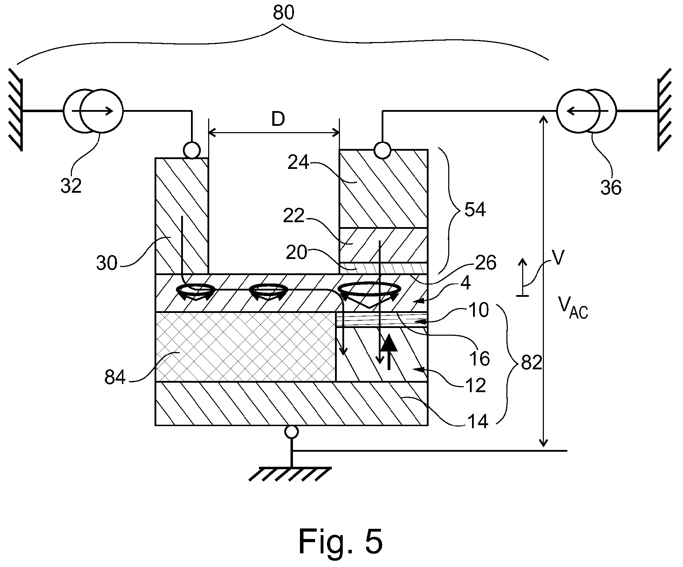

La figure 5 représente un oscillateur radiofréquence 80 identique à l'oscillateur radiofréquence 50 à l'exception du fait que l'injecteur 52 est remplacé par un injecteur 82. L'injecteur 82 est identique à l'injecteur 52 sauf que celui-ci est conformé de manière à ce que la totalité des faces d'injection 16 et de mesure 26 sont en face l'une de l'autre de chaque côté de la couche 4.

Par exemple, à cet effet, le diamètre de l'espaceur 10 et du polariseur 12 sont réduits et égaux au diamètre de la face de mesure 26. L'espace libre situé en dessous de la couche 4 libéré par la réduction du diamètre de l'espaceur 10 et du polariseur 12 est par exemple rempli d'un matériau non magnétique électriquement isolant tel qu'un diélectrique 84.

Dans ce mode de réalisation, la précession de l'aimantation dans la couche 4 est uniquement mesurée à l'emplacement où l'amplitude de celle-ci est maximale. Ceci améliore la sensibilité de l'oscillateur radiofréquence 80. De plus, dans ce mode de réalisation, la distance D qui sépare le contact magnétorésistif 54 du plot 30 peut être quelconque.

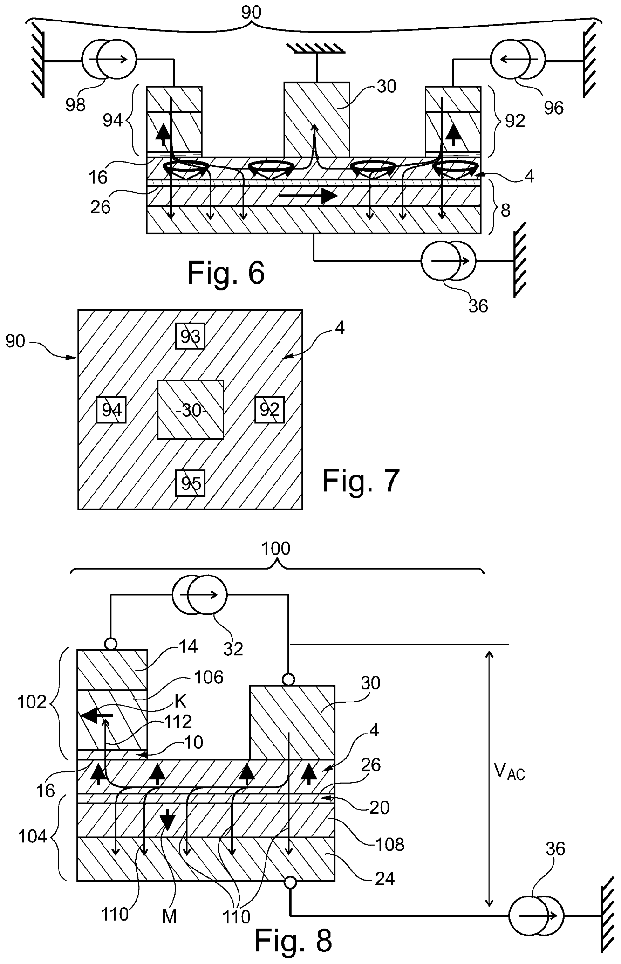

Les figures 6 et 7 représentent un oscillateur radiofréquence 90 identique à l'oscillateur radiofréquence 2 à l'exception que l'injecteur 6 est remplacé par plusieurs injecteurs disposés sur la face supérieure de la couche 4. A titre d'illustration, l'injecteur 6 est ici remplacé par quatre injecteurs 92 à 95 régulièrement répartis autour du plot 30. Par exemple, chaque injecteur 92 à 95 est identique à l'injecteur 6.

Ici, chaque injecteur 92 à 95 est raccordé à sa propre source de courant. Seules deux sources de courant 96 et 98 sont représentées sur la figure 6.

Le fonctionnement de cet oscillateur 90 se déduit du fonctionnement de l'oscillateur 2.

L'utilisation de plusieurs injecteurs permet d'augmenter le facteur de qualité et la puissance du signal mesuré par le contact magnétorésistif 8.

La figure 8 représente un oscillateur radiofréquence 100 identique à l'oscillateur radiofréquence 2 à l'exception du fait que l'injecteur 6 et le contact magnétorésistif 8 sont remplacés, respectivement, par un injecteur 102 et un contact magnétorésistif 104.

L'injecteur 102 est par exemple identique à l'injecteur 6 sauf que le polariseur 12 est remplacé par un polariseur 106 dont l'aimantation (flèche K) est parallèle au plan de la couche libre 4.

Le contact magnétorésistif 104 est par exemple identique au contact 8 sauf que la couche de référence 22 est remplacée par une couche de référence 108 dont l'aimantation est cette fois-ci perpendiculaire au plan de la couche 4.

Dans ce mode de réalisation, la source de courant 32 est raccordée entre le plot 30 et l'électrode 14 de l'injecteur 102. Des flèches 110 et 112 représentent schématiquement des lignes de courant circulant au travers de cet oscillateur 100.

Dans ce mode de réalisation, le polariseur est par exemple remplacé par une couche de référence piégée ou par un SAF.

De nombreux autres modes de réalisation sont possibles. Par exemple, d'autres dispositions des injecteurs que celle décrite en regard des figures 6 et 7 sont possibles. En particulier, les différents injecteurs peuvent être des anneaux concentriques placés autour du plot 30.

En variante, tous les injecteurs du mode de réalisation des figures 6 et 7 ou seulement certains d'entre eux sont raccordés à une même source de courant.

L'enseignement donné en regard des figures 6 et 7 peut être appliqué aux oscillateurs 50, 70 et 80. Dans le cas des oscillateurs 50 et 70, plusieurs contacts magnétorésistifs sont répartis sur la face supérieure de la couche libre 4. Dans le cas de l'oscillateur 80, cela conduit à augmenter, de part et d'autre de la même couche libre 4, le nombre d'injecteurs et de contacts magnétorésistifs dont les faces sont totalement en vis-à-vis les unes des autres.

Dans l'ensemble des modes de réalisation décrits, le polariseur peut être remplacé par une couche de référence dont l'aimantation est piégée dans une direction fixe non nécessairement perpendiculaire au plan de la couche libre.

Le sens du courant généré par la ou les sources de courant peut être inversé de sorte que les différentes lignes de courant représentées ne sont données ici qu'à titre d'illustration d'un mode possible de fonctionnement.

La source de courant qui fait circuler le courant au travers du contact magnétorésistif peut être omise si le courant qui traverse naturellement la barrière tunnel est suffisant pour permettre la mesure de la variation de résistance de la jonction tunnel.

Les deux sources de courant peuvent être remplacées par une seule source de courant en raccordant en parallèle le plot 30 et le contact magnétorésistif aux bornes d'une seule et unique source de courant. La majorité du courant traverse alors l'injecteur puis le plot conducteur car la barrière tunnel présente une résistivité beaucoup plus élevée. Ceci a par exemple été représenté dans le mode de réalisation de la figure 3.

Quel que soit le mode de réalisation décrit, l'espaceur de l'injecteur peut être remplacé par une barrière tunnel en matériau non magnétique isolant de manière à former, en combinaison avec la couche libre, une jonction tunnel. Dans ce cas, pour conserver une bonne conductivité, le facteur RA de la barrière tunnel est de préférence choisi inférieur à 5 $\Omega\mu m^2$.

Le plot conducteur peut être formé par un empilement de plusieurs métaux non magnétiques conducteurs.

La couche libre peut être formée d'un empilement de couches. Typiquement, cet empilement de couches forme alors un SAF.

**Revendications**

1. Oscillateur radiofréquence comportant :

    - une couche libre (4) dont l'aimantation précesse quand elle est traversée par un courant polarisé en spin perpendiculairement à son plan,
    - un injecteur (6; 52; 72 ; 82; 92-95; 102) de courant polarisé en spin dans la couche libre pour faire précesser de façon entretenue son aimantation, cet injecteur présentant une face d'injection (16) du courant polarisé en spin directement en contact avec la couche libre,
    - un contact magnétorésistif (8; 54; 104) présentant une face de mesure (26) directement en contact avec la couche libre pour former, en combinaison avec la couche libre, une jonction tunnel permettant de mesurer la précession de l'aimantation de la couche libre,
    - un plot conducteur (30), dont la conductivité est supérieure à celle du contact magnétorésistif, directement en contact avec la couche libre pour faire circuler à travers l'injecteur un courant électrique sans traverser le contact magnétorésistif,
    - au moins une source (32, 36; 62; 96, 98) de courant, électriquement raccordée à l'injecteur et/ou au contact magnétorésistif, apte à faire circuler un courant dont l'intensité est supérieure à l'intensité d'un courant critique $I_c$ au-delà de laquelle l'aimantation de la couche libre précesse,
    **caractérisé en ce qu'**au moins une partie des faces de mesure (26) et d'injection (16) sont disposées l'une en face de l'autre de chaque côté de la couche libre (4).

2. Oscillateur selon la revendication 1, dans lequel la source (32, 36; 62; 96, 98) de courant est électriquement raccordée à l'injecteur et/ou au contact magnétorésistif de manière à faire circuler du courant à travers les parties des faces de mesure et d'injection l'une en face de l'autre.

3. Oscillateur selon l'une quelconque des revendications précédentes, dans lequel la face de mesure (26) s'étend au-delà de la face d'injection (16).

4. Oscillateur selon la revendication 3, dans lequel la superficie de la face de mesure (26) est au moins deux fois supérieure à la superficie de la face d'injection (16).

5. Oscillateur selon l'une quelconque des revendications 1 à 2, dans lequel la face d'injection (16) s'étend au-delà de la face de mesure (26) en direction du plot conducteur.

6. Oscillateur selon l'une quelconque des revendications 1 à 2, dans lequel la totalité des faces de mesure (26) et d'injection (16) sont disposées l'une en face de l'autre.

7. Oscillateur selon l'une quelconque des revendications précédentes, dans lequel l'oscillateur comporte une source de courant (62) à laquelle sont raccordés en parallèle le plot conducteur (30) et le contact magnétorésistif (54).

8. Oscillateur selon l'une quelconque des revendications précédentes, dans lequel le facteur RA de la barrière tunnel (20) du contact magnétorésistif est supérieur à 1 $\Omega\mu m^2$ et de préférence supérieur à 20 ou 50 $\Omega\mu.m^2$.

9. Oscillateur selon l'une quelconque des revendications précédentes, dans lequel l'injecteur (102) comprend un polariseur (106) apte à polariser en spin le courant qui le traverse perpendiculairement au plan de sa couche et dont la direction de plus facile aimantation est perpendiculaire au plan de la couche libre (4).

10. Oscillateur selon l'une quelconque des revendications précédentes, dans lequel l'injecteur comprend un polariseur (12) et une couche non magnétique conductrice (10) apte à découpler magnétiquement le polariseur de la couche libre (4) de manière à ce que l'empilement du polariseur, de la couche non magnétique conductrice et de la couche libre forme une magnétorésistance géante.

11. Oscillateur selon l'une quelconque des revendications 1 à 9, dans lequel l'injecteur comprend un polariseur (12) et une couche non magnétique électriquement isolante (74) apte à découpler magnétiquement le polariseur de la couche libre (4) de manière à ce que l'empilement du polariseur, de la couche non magnétique et de la couche libre forme une jonction tunnel.

12. Oscillateur selon la revendication 10 ou 11, dans lequel le polariseur est un antiferromagnétique synthétique.

13. Oscillateur selon l'une quelconque des revendications précédentes, dans lequel la couche libre est un antiferromagnétique synthétique.

14. Procédé de génération d'oscillations radiofréquences à l'aide d'un oscillateur radiofréquence conforme à l'une quelconque des revendications précédentes, dans lequel, au moins une source de courant est commandée pour faire circuler du courant à travers les parties des faces de mesure et d'injection l'une en face de l'autre et, simultanément, pour faire circuler un courant directement de l'injecteur vers le plot conducteur sans passer par l'intermédiaire du contact magnéto-résistif.

15. Procédé selon la revendication 14, dans lequel l'intensité du courant qui traverse le contact magnéto-résistif est au moins deux fois inférieure à l'intensité du courant qui traverse, au même instant, l'injecteur.

**Patentansprüche**

1. HF-Oszillator, der Folgendes umfasst:

- eine freie Schicht (4), deren Magnetisierung präzessiert, wenn sie von einem senkrecht zu ihrer Ebene spin-polarisierten Strom durchquert wird,
- einen Injektor (6; 52; 72; 82; 92-95; 102) spin-polarisierten Stroms in die freie Schicht, um ihre Magnetisierung anhaltend präzessieren zu lassen, wobei dieser Injektor eine Injektionsfläche (16) des spin-polarisierten Stroms direkt in Berührung mit der freien Schicht aufweist,
- einen magnetoresistiven Kontakt (8; 54; 104), der eine Messfläche (26) direkt in Kontakt mit der freien Schicht aufweist, um kombiniert mit der freien Schicht einen Tunnelübergang zu bilden, der es erlaubt, die Präzession der Magnetisierung der freien Schicht zu messen,
- ein leitendes Kontaktelement (30), dessen Leitfähigkeit größer ist als die des magnetoresistiven Kontakts, direkt in Berührung mit der freien Schicht, um durch den Injektor einen elektrischen Strom zirkulieren zu lassen, ohne den magnetoresistiven Kontakt zu durchqueren,
- mindestens eine Stromquelle (32, 36; 62; 96, 98), die elektrisch an den Injektor und/oder an den magnetoresistiven Kontakt angeschlossen ist, die geeignet ist, einen Strom zirkulieren zu lassen, dessen Stärke größer ist als die Stärke eines kritischen Stroms $I_c$, über welchen hinaus die Magnetisierung der freien Schicht präzessiert,

**dadurch gekennzeichnet, dass** mindestens ein Teil der Mess- (26) und Injektionsflächen (16) einander gegenüberliegend auf jeder Seite der freien Schicht (4) angeordnet ist.

2. Oszillator nach Anspruch 1, wobei die Stromquelle (32, 36; 62; 96, 98) elektrisch an den Injektor und/oder an den magnetoresistiven Kontakt derart angeschlossen ist, dass Strom durch die Teile der Mess- und Injektionsflächen, die einander gegenüber liegen, zirkuliert.

3. Oszillator nach einem der vorhergehenden Ansprüche, wobei sich die Messfläche (26) über die Injektionsfläche (16) hinaus erstreckt.

4. Oszillator nach Anspruch 3, wobei die Oberfläche der Messfläche (26) mindestens zweimal größer ist als die Oberfläche der Injektionsfläche (16).

5. Oszillator nach einem der Ansprüche 1 bis 2, wobei sich die Injektionsfläche (16) über die Messfläche (26) in Richtung des leitenden Kontaktelements hinaus erstreckt.

6. Oszillator nach einem der Ansprüche 1 bis 2, wobei die gesamte Messfläche (26) und Injektionsfläche (16) einander gegenüber angeordnet sind.

7. Oszillator nach einem der vorhergehenden Ansprüche, wobei der Oszillator eine Stromquelle (62) umfasst, an die parallel das leitende Kontaktelement (30) und der magnetoresistive Kontakt (54) angeschlossen sind.

8. Oszillator nach einem der vorhergehenden Ansprüche, wobei der RA-Faktor des Tunnelübergangs (20) des magnetoresistiven Kontakts größer ist als 1 $\Omega\mu m^2$ und vorzugsweise größer als 20 oder 50 $\Omega\mu m^2$.

9. Oszillator nach einem der vorhergehenden Ansprüche, wobei der Injektor (102) einen Polarisator (106) umfasst, der geeignet ist, den Strom, der ihn senkrecht zu der Ebene seiner Schicht durchquert, zu spin-polarisieren, und dessen Richtung mit der einfachsten Magnetisierung zu der Ebene der freien Schicht (4) senkrecht ist.

10. Oszillator nach einem der vorhergehenden Ansprüche, wobei der Injektor einen Polarisator (12) und eine nicht magnetische leitende Schicht (10) umfasst, die geeignet ist, den Polarisator magnetisch von der freien Schicht (4) derart abzukoppeln, dass die Stapelung des Polarisators, der nicht magnetischen leitenden Schicht und der freien Schicht einen Riesenmagnetowiderstand bildet.

11. Oszillator nach einem der Ansprüche 1 bis 9, wobei der Injektor einen Polarisator (12) und eine nicht magnetische elektrisch isolierende Schicht (74) umfasst, die geeignet ist, den Polarisator von der freien Schicht (4) derart abzukoppeln, dass die Stapelung des Polarisators, der nicht magnetischen Schicht und der freien Schicht einen Tunnelübergang bildet.

12. Oszillator nach Anspruch 10 oder 11, wobei der Polarisator ein synthetisches Antiferromagnetmaterial ist.

13. Oszillator nach einem der vorhergehenden Ansprüche, wobei die freie Schicht ein synthetisches Antiferromagnetmaterial ist.

**14.** Verfahren zum Erzeugen von HF-Oszillationen mit Hilfe eines HF-Oszillators nach einem der vorhergehenden Ansprüche, wobei mindestens eine Stromquelle gesteuert wird, um Strom durch die Teile der Mess- und Injektionsflächen, die einander gegenüber liegen, zirkulieren zu lassen, und um gleichzeitig einen Strom direkt von dem Injektor zu dem leitenden Kontaktelement zirkulieren zu lassen, ohne über den magnetoresistiven Kontakt zu laufen.

**15.** Verfahren nach Anspruch 14, wobei die Stärke des Stroms, der den magnetoresistiven Kontakt durchquert, mindestens zwei Mal niedriger ist als die Stärke des Stroms, der gleichzeitig den Injektor durchquert.

**Claims**

**1.** Radiofrequency oscillator comprising:

- a free layer (4), the magnetization of which precesses when a spin-polarized current passes through it perpendicularly to its plane,
- an injector (6; 52; 72; 82; 92-95; 102) of spin-polarized current into the free layer in order to make its magnetization precess in a sustained fashion, this injector having a spin-polarized current injection face (16) directly in contact with the free layer,
- a magnetoresistive contact (8; 54; 104) having a measurement face (26) directly in contact with the free layer in order to form, in combination with the free layer, a tunnel junction making it possible to measure the precession of the magnetization of the free layer,
- a conductive pad (30), the conductivity of which is greater than that of the magnetoresistive contact, directly in contact with the free layer in order to make an electrical current flow through the injector without passing through the magnetoresistive contact,
- at least one current source (32, 36; 62; 96, 98) which is electrically connected to the injector and/or to the magnetoresistive contact and is adapted to make a current flow, the strength of which is greater than the strength of a critical current $I_c$ above which the magnetization of the free layer precesses,
**characterized in that** at least a part of the measurement face (26) and a part of the injection face (16) are arranged opposing one another on either side of the free layer (4).

**2.** Oscillator according to Claim 1, wherein the current source (32, 36; 62; 96, 98) is electrically connected to the injector and/or to the magnetoresistive contact so as to make current flow through the parts of the measurement and injection faces which oppose one another.

**3.** Oscillator according to either of the preceding claims, wherein the measurement face (26) extends beyond the injection face (16).

**4.** Oscillator according to Claim 3, wherein the surface area of the measurement face (26) is at least two times greater than the surface area of the injection face (16).

**5.** Oscillator according to either of Claims 1 and 2, wherein the injection face (16) extends beyond the measurement face (26) in the direction of the conductive pad.

**6.** Oscillator according to either of Claims 1 and 2, wherein the entire measurement face (26) and the entire injection face (16) are arranged opposing one another.

**7.** Oscillator according to any one of the preceding claims, wherein the oscillator comprises a current source (62) to which the conductive pad (30) and the magnetoresistive contact (54) are connected in parallel.

**8.** Oscillator according to any one of the preceding claims, wherein the RA factor of the tunnel barrier (20) of the magnetoresistive contact is greater than $1\,\Omega\mu m^2$ and preferably greater than 20 or 50 S2pm2.

**9.** Oscillator according to any one of the preceding claims, wherein the injector (102) comprises a polarizer (106) which is adapted to spin-polarize the current which passes through it perpendicularly to the plane of its layer and whose direction of easiest magnetization is perpendicular to the plane of the free layer (4).

**10.** Oscillator according to any one of the preceding claims, wherein the injector comprises a polarizer (12) and a conductive nonmagnetic layer (10) adapted to magnetically decouple the polarizer from the free layer (4), so that the stack consisting of the polarizer, the conductive nonmagnetic layer and the free layer forms a giant magnetoresistance.

**11.** Oscillator according to any one of Claims 1 to 9, wherein the injector comprises a polarizer (12) and an electrically insulating nonmagnetic layer (74) adapted to magnetically decouple the polarizer from the free layer (4), so that the stack consisting of the polarizer, the nonmagnetic layer and the free layer forms a tunnel junction.

12. Oscillator according to Claim 10 or 11, wherein the polarizer is a synthetic antiferromagnetic.

13. Oscillator according to any one of the preceding claims, wherein the free layer is a synthetic antiferromagnetic.

14. Method for generating radiofrequency oscillations with the aid of a radiofrequency oscillator according to any one of the preceding claims, wherein at least one current source is controlled in order to make current flow through the parts of the measurement and injection faces which oppose one another and, simultaneously, in order to make a current flow directly from the injector to the conductive pad without passing through the magnetoresistive contact.

15. Method according to Claim 14, wherein the strength of the current which passes through the magnetoresistive contact is at least two times less than the strength of the current which flows through the injector at the same time.

Fig. 1

Fig. 2

Fig. 3

Fig. 4

Fig. 5

Fig. 6

Fig. 7

Fig. 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5695864 A
- FR 2892271
- US 20070259209 A
- US 20080094760 A1
- WO 2009130738 A1
- FR 2817998

**Littérature non-brevet citée dans la description**

- **BAIBICH, M. ; BROTO, J.M. ; FERT, A. ; NGUYEN VAN DAU, F. ; PETROFF, F. ; ETIENNE, P. ; CREUZET, G. ; FRIEDERCH, A. ; CHAZELAS, J.** Giant magnetoresistance of (001)Fel(001)Cr magnetic superlattices. *Phys.Rev.Lett.,* 1988, vol. 61, 2472
- **MOODERA, JS. ; KINDER, LR. ; WONG, TM. ; MESERVEY,R.** Large magnetoresistance at room temperature in ferromagnetic thin film tunnel junctions. *Phys.Rev.Lett,* 1995, vol. 74, 3273-6
- **KATINE, J.A. ; ALBERT, F.J. ; BUHRMAN, R.A. ; MYERS, E.B. ; RALPH, D.C.** Current-Driven Magnetization Reversal and Spin-Wave Excitations in Co lCu /Co Pillars. *Phys.Rev.Lett.,* 2000, vol. 84, 3149
- **KISELEV, S.I. ; SANKEY, J.C. ; KRIVOROTOV, LN. ; EMLEY, N.C. ; SCHOELKOPF, R.J. ; BUHRMAN, R.A. ; RALPH, D.C.** Microwave oscillations of a nanomagnet driven by a spin-polarized current. *Nature,* 2003, vol. 425, 380
- **S. PARKIN et al.** *Physical Review B,* 1991, vol. 44 (13
- **S. PARKIN et al.** *Physical Review Letters,* 1990, vol. 64 (19